# EUROPEAN PATENT APPLICATION

(11) **EP 3 367 556 A1**
(43) Date of publication of application: **29.08.2018**
(21) Application number: 18156058.2
(22) Date of filing: 09.02.2018
(51) Int. Cl.: H02P 9/02, G01R 31/34

(54) **DEVICE AND PROCEDURE FOR TESTING A POWER MODULE COMPRISING A MULTICHANNEL POWER CONVERTER AND A SYNCHRONOUS MULTIPHASE AND MULTICHANNEL ELECTRICAL MACHINE**

(30) Priority: 24.02.2017 FR 1751468
(71) Applicant: GE Energy Power Conversion Technology Ltd, Rugby Warwickshire CV21 1BU (GB)
(72) Inventor: PERON, Régis, 90000 Belfort (FR); HAJI, Abderrahmane, 90000 Belfort (FR)
(74) Representative: Fischer, Michael Maria

(57) **Abstract**

A device for testing a power module comprising a multichannel power converter (11) and a synchronous multiphase and multichannel electrical machine (10) intended to be supplied by the converter (11), whereby the synchronous multiphase and multichannel electrical machine (10) has phases connected to one another by groups of three phases (13, 14, 15). The power converter (11) comprises as many voltage inverters as there are groups of three phases connected to said converter, whereby each inverter is connected to a group of three phases (13, 14, 15).

## Description

The invention relates to a device and a procedure for testing an electrical power module, and more particularly a procedure for testing a synchronous multiphase and multichannel electrical machine and its associated multichannel power converter.

Before delivering an electrical power module to a customer, the manufacturer aims to verify the correct operation of the module. This module comprises a power converter and an electrical machine powered by said power converter. The manufacturer aims to verify the electrical and mechanical characteristics of the module. It also aims to verify the operation of the control and acquisition chains comprising sensors, interfacing modules, and actuators. It aims to optimize the costs of the testing operations, and to reduce the investments related to the manufacturing of the test bench.

In addition, the power module customer also wishes to test the power module.

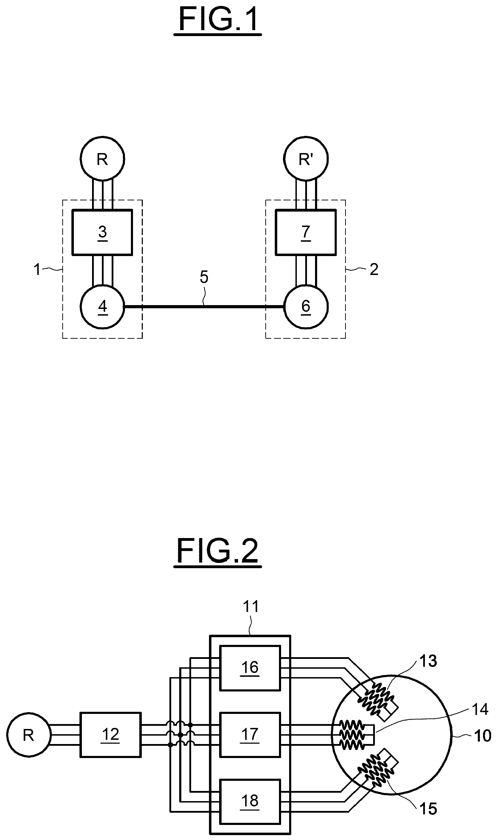

The usual procedure for testing an electrical power module includes a test bench specific to the tests conducted, known as a "back-to-back test bench". This test procedure requires that the assembly being tested, comprising the electrical machine and its associated power converter, be mounted on the test bench. The test bench is a large and very heavy device. For example, a test bench for of a generator suitable for a wind turbine weighs around 140 tons. Figure 1 shows a back-to-back test bench specific to these tests, as known from the standard technique.

The test bench comprises two electrical power modules 1 and 2. A first electrical power module 1 comprises a power converter 3 which supplies an electrical machine 4 operating in motor mode. The shaft of the motor 5 of this first electrical power module is mechanically connected to the shaft of the second power module 2. The second power module 2, which is the object of the test procedure, comprises an electrical machine 6 associated with a power converter 7. The second power module 2 operates in generator mode. The first power module 1 is supplied by a three-phase electrical network R. It drives the second power module 2 connected to a three-phase network R'. The electrical and mechanical characteristics of the second power module recorded during the test procedure are analyzed, and allow it to be concluded whether the tested power module 2 conforms or not.

A second test is performed on the integration line of the module in its environment before shipping, such as in the case of a wind turbine, when the power module is mounted in the nacelle of the wind turbine. This is a functional test. The power module is supplied by an external source. It is checked that the axle of the electrical machine starts to move.

However, the usual test procedures have several disadvantages.

The module being tested must be mounted on a test bench, which implies that the assembly cannot be tested in its working environment, and customers that are not equipped with such a test bench cannot test their power module easily.

For example, in the case of a power module operating in generator mode and equipping an offshore wind turbine, the power module cannot be tested when it is integrated into the nacelle of the wind turbine and connected to all of the auxiliary components. The interfaces connecting the power unit to the other components cannot be tested either.

In addition, the test procedure performed prior to shipping the module is brief. It involves ensuring that the powertrain is able to drive the shaft of the electrical machine. No diagnosis can be made regarding the quality of the devices comprising the power module, such as the sensors included in the nacelle which perform the acquisition of the characteristics of the electrical machine.

The global acquisition and control chains linked between the power converters and the nacelle cannot be tested under real operating conditions.

The objective of the invention is therefore to eliminate these disadvantages.

In view of this, the invention proposes a device for testing a power module comprising a multichannel power converter and a synchronous multiphase and multichannel electrical machine intended to be supplied by the converter, whereby the synchronous multiphase and multichannel electrical machine has phases connected to one another by groups of three phases.

One characteristic of the device according to the invention is that the power converter comprises as many voltage inverters as there are groups of three phases connected to said converter, whereby each inverter is connected to a group of three phases.

Another characteristic of the invention is that the three phases of a group are connected in a star or delta configuration or by any other coupling.

Advantageously, the stator of the synchronous multiphase and multichannel electrical machine comprises a plurality of groups of three phases with a magnetic coupling level to make it possible to control each channel separately.

Preferably, the synchronous multiphase and multichannel electrical machine operates in motor or generator mode.

Another characteristic of the device is that the shaft of the synchronous multiphase and multichannel electrical machine is free.

The invention also relates to a procedure for testing a power module comprising a multichannel power converter and a synchronous multiphase and multichannel electrical machine intended to be supplied by the converter, whereby the synchronous multiphase and multichannel electrical machine comprises a stator comprising phases connected to one another by groups of three phases, the groups of phases are magnetically decoupled from each other and are each connected to the multichannel power converter, and a transformer connected to a three-phase electrical network supplies the multichannel power converter.

Another characteristic of the procedure according to the invention is that it comprises at least one step whereby a group of three phases drives the rotor of the electrical machine at a predetermined rotational speed, and one or more other groups of three phases that form the object of the test procedure operate in generator mode and apply electromagnetic torque to the rotor of the synchronous multiphase and multichannel electrical machine.

Advantageously, the three phases of a group are connected in a star or delta configuration or by any other coupling.

Another characteristic of the procedure according to the invention is that the transformer supplies the multichannel power converter with a power value equal to the value of the power lost during the various energy conversion steps.

Advantageously, during the different test steps, only active powers are exchanged between the multichannel power converter, the synchronous multiphase and multichannel electrical machine and the transformer.

Other objectives, characteristics and advantages of the invention will become apparent on reading the following description, given solely by way of a non-limiting example, with reference to the accompanying drawings, in which:
- Fig. 1, which has already been mentioned, shows a test bench of a powertrain as known from the standard technique;
- Fig. 2 shows an electrical power diagram of an electrical power module comprising a multiphase synchronous electrical machine and a multichannel power converter;
- Fig. 3 describes a channel of the multichannel power converter; and
- Fig. 4 shows the electrical power exchanges of the test procedure according to the invention.

Reference is made to Fig. 2, which shows an electrical power diagram of an electrical power module comprising a multiphase and multichannel electrical machine and a multichannel power converter. For example, in a non-limiting application, the power module is intended to be integrated into the nacelle of a wind turbine.

The power circuit of the power module comprises a multichannel three-phase power converter 11 and a synchronous multiphase and multichannel electrical machine 10 supplied by the converter. The same-phase inputs of the power converter 11 are connected to one another and to the corresponding output of a three-phase transformer 12. The transformer 12 is supplied by a three-phase electrical network R. The entire device comprising the power converter 11 and the multiphase and multichannel electrical machine 10 is controlled by a control device (not shown).

The synchronous multiphase and multichannel electrical machine 10 comprises a stator and a rotor. The stator includes a plurality of phases that are multiples of three. The phases are connected to one another by groups of three phases. By way of a non-limiting example hereunder, the three phases of a group are connected in a star configuration. Of course, there is no departure from the invention when the phases are connected in any configuration whatsoever, in particular but not exclusively in a delta configuration. The stars have a strong magnetic decoupling between them. As a result, the magnetic fluxes generated by one star do not disturb another star. The magnetic decoupling level allows each channel to be controlled separately.

In Fig. 2, the machine 10 comprises, for example, nine phases grouped into three groups of triple phases 13, 14, 15 connected in a star configuration.

The power converter 11 has a plurality of identically formed channels.

Each output of a channel is connected to a group of triple phases in the star configuration of the electrical machine 10. Therefore, the number of channels of the power converter 11 is equal to the number of triple-phase groups in the star configuration of the machine 10. The inputs of the same-phase channels are connected to one another and to the corresponding output of the transformer 12.

In Fig. 2, the electrical machine comprises three groups of triple phases in a star configuration 13, 14 and 15. Therefore, the power converter 11 comprises three channels 16, 17, 18.

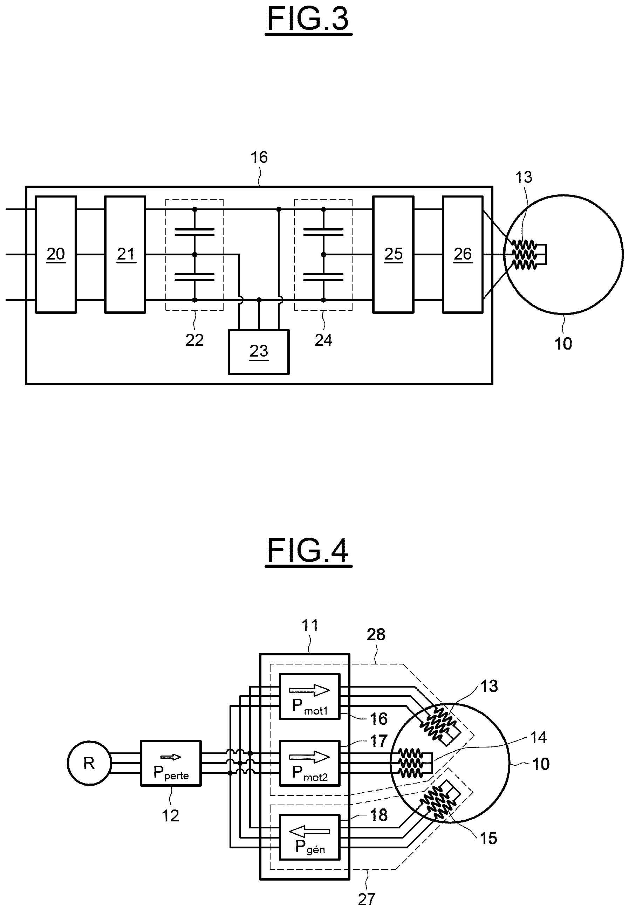

Reference is made to Fig. 3, which shows the formation of the channel 16 of the multichannel power converter 11. All channels are formed identically.

Channel 16 comprises a harmonic filtering device 20 whose inputs are intended to be connected to the transformer 12 and to the other channel inputs of the power converter 11. The outputs of the filter 20 are connected to the inputs of a controlled and reversible bridge rectifier 21. The outputs of the bridge rectifier 21 are connected to a capacitor bank 22. The DC voltage filtering assembly 22 comprises two groups of series-connected capacitors whose ends are connected to the rectifier bridge 21, to a brake chopper 23 and to the inputs of a reversible voltage inverter 25, and whose midpoint between the two capacitors is connected to the brake chopper. A second capacitor bank 24 formed identically to capacitor bank 22 is connected to the inputs of the reversible voltage inverter 25. The midpoint between the two capacitors of the capacitor bank 24 is connected to the reversible voltage inverter 25. The outputs of the voltage inverter 25 are connected to a dV/dT filter 26. The outputs of the filter 26 are connected to a group of triple phases in the star configuration of the electrical machine 10.

The filtering device 20, the controlled and reversible bridge rectifier 21, the brake chopper 23, the reversible voltage inverter 25 and the dV/dT filter 26 are not discussed in detail here, since these elements are known to skilled technicians.

Reference is made to Fig. 4, which shows the power exchange fluxes during the test procedure of a star assembly and an associated voltage inverter. The test procedure is repeated for each group of triple phases or for a plurality of groups of triple phases in the star configuration of the electrical machine 10 and the associated channel(s) of the power converter 11 being tested.

The test procedure is shown, for example, in the assembly 27, which comprises the triple-phase group in a star configuration 15 and the channel 18 of the power converter 11.

The rotor of the electrical machine 10 is set in motion by the assembly 28, which comprises the triple-phase groups in a star configuration 13 and 14 supplied by the channels 16 and 17 of the power converter 11. The assembly 27 is initially supplied by the transformer 12. The triple-phase groups in a star configuration 13 and 14 are called motor groups.

The number of triple-phase motor groups in a star configuration is chosen such that the total rated power output delivered by the stars is at least equal to the rated power of the tested assembly.

The electrical machine 10 is controlled in terms of its speed.

When the rotor of the electrical machine 10 reaches the connection speed, and after the synchronization of the assembly 27, the assembly 27 being tested is controlled such that it operates in power generation mode.

The connection speed corresponds to the rotational speed from which the electrical machine and the power converter assembly would produce sufficient power to supply an electrical network if they were operating in generator mode. In the case of a wind turbine, for example, the connection speed is 3.7 rpm.

The assembly 27 controls the electrical machine 10 in terms of its torque.

The electrical power P_{gen} generated by the assembly 27 is transferred to the motor assembly 28. The motor powers Pₘₒₜ₁ and Pₘₒₜ₂ consumed by the assembly 27 are equal to the sum of the power P_{gen} and the power lost during the various energy conversion steps Pₗₒₛₛ.

The transformer 12 compensates for the losses generated by the electrical machine 10 and the power converter 11. The electrical network R now only provides the power lost during the energy conversion steps Pₗₒₛₛ.

The dimensions of the transformer are reduced, for example for an electrical machine 10 with a rated power of 6 MW, i.e. a power of 2 MW per group of triple phases in a star configuration, if two groups of triple phases in a star configuration are motor groups. A transformer with a power of a few dozen KW is therefore sufficient to conduct the test procedure.

Advantageously, only active power flows are exchanged between the transformer 12, the multichannel three-phase power converter 11 and the synchronous multiphase and multichannel electrical machine 10.

The resistive electromagnetic torque generated by the assembly 27 comprising a group of triple phases in a star configuration 15 and the channel 18 of the associated power converter 11 applied to the rotor of the electrical machine 10 is increased gradually. As a result, the rotational speed of the rotor decreases. The control system increases the motor power delivered by the assembly 28 until the rotational speed setpoint is reached. The resistive torque can thus be increased until the power generated by the resistive torque is equal to the motor power generated by the assembly 28. The power generated by the assembly 27 is compared to the expected values in order to validate the operation of the assembly 27.

This test procedure has the advantage of testing the power module over its entire range of use by using the acquisition, control and power chains of the module in its environment, such as in the case of a wind turbine, when the power module is mounted in the nacelle of the wind turbine. Advantageously, the test device has an architecture that makes it possible to perform power exchanges within the power module without a mechanical interface 5 with another test module in rotation. The power modules 11 can thus be tested functionally (in terms of their control and power) prior to shipping the machine 10.

## Claims

1. A device for testing a power module comprising a multichannel power converter (11) and a synchronous multiphase and multichannel electrical machine (10) to be supplied by the converter (11), whereby the synchronous multiphase and multichannel electrical machine (10) has phases connected to one another by groups of three phases (13, 14, 15), **characterized in that** the power converter (11) comprises as many voltage inverters (25) as there are groups of three phases connected to said converter, whereby each inverter (25) is connected to one group of three phases (13, 14, 15).

2. A device according to claim 1, **characterized in that** the three phases of a group are connected in a star or delta configuration or by any other coupling.

3. A device according to one of claims 1 or 2, **characterized in that** the stator of the synchronous multiphase and multichannel electrical machine comprises a plurality of groups of three phases (13, 14, 15) with a magnetic coupling level making it possible to control each channel separately.

4. A device according to one of claims 1 to 3, **characterized in that** the synchronous multiphase and multichannel electrical machine (10) operates in motor or generator mode.

5. A device according to one of claims 1 to 4, **characterized in that** the shaft of the multiphase and multichannel electrical machine (10) is free.

6. A procedure for testing a power module comprising a multichannel power converter (11) and a synchronous multiphase and multichannel electrical machine (10) intended to be supplied by the converter (11), whereby the synchronous multiphase and multichannel electrical machine (10) comprises a stator comprising phases connected to one another by groups of three phases (13, 14, 15); the groups of three phases (13, 14, 15) are magnetically decoupled from each other and each is connected to the multichannel power converter (11); and a transformer (12) connected to a three-phase electrical network (R) supplies the multichannel power converter (11). It is **characterized in that** the procedure comprises at least one step whereby a group of three phases (13, 14, 15) drives the rotor of the electrical machine at a predetermined rotational speed, and one or more other groups of three phases that form the object of the test procedure operate in generator mode and apply an electromagnetic torque to the rotor of the synchronous multiphase and multichannel electrical machine (10).

7. A procedure according to claim 6, **characterized in that** the three phases of a group are connected in a star or delta configuration or by any other coupling.

8. A procedure according to one of claims 6 or 7, **characterized in that** the transformer (12) supplies the multichannel power converter with a power value equal to the value of the power lost during the various energy conversion steps.

9. A procedure according to one of claims 6 to 8, **characterized in that**, during the different test steps, only active powers are exchanged between the multichannel power converter (11), the synchronous multiphase and multichannel electrical machine (10) and the transformer (12).
